# EUROPEAN PATENT SPECIFICATION

(11) **EP 0 793 695 B1**
(45) Date of publication and mention of the grant of the patent: **05.01.2000**
(21) Application number: 95938742.4
(22) Date of filing: 17.10.1995
(51) Int. Cl.: C09J 7/00, C09J 133/00, C08F 220/00

(54) **Damping constructions comprising at least one layer of a viscoelastic material applied to a vibratory solid article**
Dämpfende konstruktionen enthaltend mindestens eine Schlicht aus einem viskoelastischen Material auf einem vibrierenden Festkörper
Elements amortissants comprenant au moins une couche de matériau viscoélastique sur un objet solide vibratoire

(30) Priority: 22.11.1994 US 343247
(43) Date of publication of application: 10.09.1997
(73) Proprietor: MINNESOTA MINING AND MANUFACTURING COMPANY, St. Paul, Minnesota 55133-3427 (US)
(72) Inventor: BENNETT, Greggory, S., Saint Paul, MN 55133-3427 (US); HAAK, Christopher, A., Saint Paul, MN 55133-3427 (US); GUSTAFSON, Craig, A., Saint Paul, MN 55133-3427 (US)
(74) Representative: Warcoin, Jacques
(86) International application number: US9513186
(87) International publication number: WO9616134

(56) References cited:
- EP-A- 0 252 717
- WO-A-95/13331
- DATABASE WPIL, no. 93-104 974, DERWENT PUBLICATIONS LTD., London; & JP,A,05 045 518 (NIPPON SYNTHETIC CEM. IND. CO.),

## Description

### Background of the Invention

### Field of the Invention

This invention relates to a damping construction comprising at least one layer of a viscoelastic material applied to a vibratory solid article.

### Description of the background Art

Acrylate pressure sensitive adhesives are well known in the art. Many of these adhesives are copolymers of an alkyl ester of acrylic acid and a minor portion of a polar co-monomer. Due to the presence of the polar co-monomer these adhesives generally do not adhere well to low energy and oily surfaces (e.g., surfaces having a critical surface tension of wetting of no greater than about 35 dynes/cm [0.035 N/m]). Although adhesion can be improved through addition of a tackifier, the degree of improvement is limited because most commercially available tackifiers are not miscible in the polar monomer-containing adhesive.

The document EP-A-0 252 717 describes adhesive compositions prepared from (a) a mixture of soft monomers including a diester of an unsaturated dicarboxylic acid (e.g., dibutyl fumarate) and a soft alkyl acrylate (e.g., butyl acrylate), (b) a hard monomer (e.g., a methacrylate), and, optionally, (c) a limited quantity of acrylic acid. The diester is a critical component of all of EP-A-0 252 717.

U.S. 5,262,232 describes acrylate-epoxy compositions useful in vibration damping articles prepared by combining, e.g., isooctyl acrylate, isobornyl acrylate, and epoxy monomers, and then irradiating the mixture with ultraviolet radiation to polymerize the acrylate monomers in the presence of the epoxy monomer. This document, however, never describes an acrylate polymer, independent of the epoxy resin, which has the requisite properties for the application to a vibratory solid article.

### Summary of the Invention

In one aspect, the invention features a damping construction comprising at least one layer of a viscoelastic material applied to a vibratory solid article, said viscoelastic material comprising the reaction product of starting materials consisting of :
(a) 3-97 parts by weight of an acrylic acid ester of a monohydric alcohol whose homopolymer has a Tg less than 0°C ;
(b) 3-97 parts by weight of a non-polar ethylenically unsaturated monomer whose homopolymer has a solubility parameter as measured by the Fedors method of no greater than 10.50 and a Tg greater than 15°C; and
(c) 0-5 parts by weight of a polar ethylenically unsaturated monomer whose homopolymer has a solubility parameter as measured by the Fedors method of greater than 10.50 and a Tg greater than 15°C,
the sum of the parts by weight of said acrylic acid ester, said non-polar ethylenically unsaturated monomer, and said polar ethylenically unsaturated monomer being equal to 100 parts,
and substantially no epoxy component,
said viscoelastic material being substantially non-tacky at room temperature.

Vibration damping is measured in terms of the loss factor which is a ratio of the energy dissipated to the energy stored. The greater the amount of energy dissipated, the greater the loss factor, and therefore the better the damping properties of the material. Vibration dampers operate over a range of temperatures and the compositions can be formulated to provide optimal damping at a desired range of temperatures.

The compositions used in the present invention provide materials for vibration dampers that are substantially non-tacky at room temperature, i.e., the sheet would not adhere instantly to a substrate at room temperature under finger pressure. Typically, the compositions having higher amounts of the nonpolar co-monomer having a homopolymer T_{g} greater than 15°C, i.e, more than about 45-50 parts, depending upon the co-monomer, are not pressure sensitive at room temperature. Ifdesired, a non-tacky damper can be adhered to a substrate by heating the substrate while in contact with the vibration damping sheet material, or the non-tacky damper may be adhered to the substrate with known adhesives, preferably rigid adhesives.

Vibration dampers of the invention are not particularly moisture sensitive and can provide advantages in areas where the damper is exposed to the atmosphere, or where outgassing, usually caused by moisture absorbed by the damper, may be a concern.

In practice, the compositions are typically formed into a sheet or a slab. The thickness of the sheet is determined to a large degree by the application, and useful thicknesses can range from about 0.015 mm to over 2.54 cm. The sheet can be applied to a constraining layer that is stiffer than the sheet to form a composite referred to as a constrained layer damper. Materials suitable for constraining layers are sheets of metal, such as aluminum and steel, and plastics, such as polyester. The constraining layer is generally selected so that the stiffness of the panel is greater than the stiffness, i.e., modulus, of the sheet material. Optimally, although not required, the stiffness of the panel is approximately equal to that ofthe object to be damped. The sheet can also be applied directly to the object to be damped as a free layer damper.

The solubility parameter referred to herein is calculated according to the technique described in Fedors, Polym. Eng. and Sci., 14:147 (1974). A monomer whose homopolymer has a solubility parameter of greater than 10.50 when measured according to the Fedors technique is referred to herein as a polar monomer, whereas a monomer whose homopolymer has a solubility parameter of 10.50 or less when measured according to the Fedors technique is referred to herein as a non-polar monomer.

A list of several common monomers and their respective Fedors' solubility parameters is shown in Table 1. Table 1 is subdivided into four sections: low T_{g} acrylate monomers, high T_{g} acrylate monomers, high Tg methacrylate monomers, and vinyl monomers.

**TABLE 1:**

| FEDORS' SOLUBILITY PARAMETERS | |
|---|---|
| Repeat Unit | Solubility Parameter (cal/cm³)^{0.5} |
| Octadecyl acrylate (ODA) | 8.99 |
| Lauryl acrylate (LA) | 9.15 |
| Iso-octyl acrylate (IOA) | 9.22 |
| 2-ethylhexyl acrylate (2-EHA) | 9.22 |
| Butyl acrylate (BA) | 9.77 |
| Propyl acrylate (PA) | 9.95 |
| Ethyl acrylate (EA) | 10.20 |
| 3,3,5 trimethylcyclohexyl acrylate (TMCA) | 9.35 |
| Iso-bornyl acrylate (IBA) | 9.71 |
| Cyclohexyl acrylate (CHA) | 10.16 |
| N-octyl acrylamide (NOA) | 10.33 |
| Tetrahydrofurfuryl acrylate (THFA) | 10.53 |
| Methyl acrylate (MA) | 10.56 |
| Glycidyl acrylate (GA) | 11.32 |
| 2-Phenoxyethylacrylate (2-PhEA) | 11.79 |
| N-vinylcaprolactam (NVC) | 12.10 |
| N,N,-Dimethylacrylamide (DMA) | 12.32 |
| N-vinyl-2-pyrrolidone (NVP) | 13.38 |
| Acrylic Acid (AA) | 14.04 |
| | |
| Methylmethacrylate (MMA) | 9.93 |
| Ethylmethacrylate (EMA) | 9.72 |
| Propylmethacrylate (PMA) | 9.57 |
| | |
| Vinyl Acetate | 10.56 |
| Styrene | 11.87 |

The rheological character of the adhesive polymer can be partially but usefully described by the T_{g} as measured by the 1 radian/second tan delta maximum temperature. In the case of adhesives designed for adhesion to low energy surfaces, it is preferable for the T_{g} as measured by the 1 radian/second tan delta maximum ofthe polymer to have a value between -45°C and 15°C, more preferably between -25°C and 0°C, and even more preferably between -20°C and -5°C. In the case of adhesives designed for adhesion to oily surfaces, it is preferable for the T_{g} as measured by the 1 radian/second tan delta maximum temperature of the polymer to have a value between -45°C and 15°C, more preferably between -35°C and 0°C, and even more preferably between -30°C and -5°C.

In both cases, the adhesives having the requisite polarity and rheological properties contain 25-97 parts (more preferably 40-85 parts) of an acrylic acid ester whose homopolymer has a T_{g} less than 0°C (more preferably less than -20°C), 3-75 parts (more preferably 15-60 parts) of a non-polar ethylenically unsaturated monomer whose homopolymer has a T_{g} greater than 15°C, and 0-5 parts (more preferably 0-3 parts) ofa polar ethylenically unsaturated monomer whose homopolymer has a T_{g} greater than 15°C.

In all cases, the acrylic acid ester is a monofunctional acrylic ester of a monohydric alcohol having from 4 to 18 carbon atoms in the alcohol moiety whose homopolymer has a T_{g} less than 0°C. Included in this class of acrylic acid esters are isooctyl acrylate, 2-ethylhexyl acrylate, isononyl acrylate, isodecyl acrylate, decyl acrylate, lauryl acrylate, hexyl acrylate, butyl acrylate, and octadecyl acrylate, or combinations thereof. In the case of octadecyl acrylate, the amount is chosen such that side chain crystallization does not occur at room temperature.

The non-polar ethylenically-unsaturated monomer is a monomer whose homopolymer has a solubility parameter as measured by the Fedors method of not greater than 10.50 and a T_{g} greater than 15°C. In a preferred embodiment, the non-polar ethylenically-unsaturated monomer is a monomer whose homopolymer has a solubility parameter as measured by the Fedors method of not greater than 10.3, more preferably not greater than 9.9. The non-polar nature of this monomer improves the low energy surface adhesion and oily surface adhesion of the adhesive. It also improves the structural properties of the adhesive (e.g., cohesive strength) relative to a homopolymer of the acrylic acid ester described above. Examples of suitable non-polar monomers include 3,3,5 trimethylcyclohexyl acrylate, cyclohexyl acrylate, isobornyl acrylate, N-octyl acrylamide, t-butyl acrylate, methyl methacrylate, ethyl methacrylate, and propyl methacrylate or combinations thereof.

The adhesive may contain a limited quantity (e.g., no more than 5 parts) of a polar ethylenically unsaturated monomer whose homopolymer has a solubility parameter as measured by the Fedors method of greater than 10.50 and a T_{g} greater than 15°C to improve structural properties (e.g., cohesive strength). It is not desirable to include more than 5 parts of the polar monomer because the polar monomer impairs low energy surface adhesion and oily surface adhesion, and reduces tackifier miscibility. Examples of suitable polar monomers include acrylic acid, itaconic acid, certain substituted acrylamides such as N,N dimethylacrylamide, N-vinyl-2-pyrrolidone, N-vinyl caprolactam, acrylonitrile, tetrahydrofurfuryl acrylate, glycidyl acrylate, 2-phenoxyethylacrylate, and benzylacrylate, or combinations thereof.

The monomer mixture can be polymerized by various techniques, with photoinitiated bulk polymerization being preferred. An initiator is preferably added to aid in polymerization of the monomers. The type of initiator used depends on the polymerization process. Photoinitiators which are useful for polymerizing the acrylate monomers include benzoin ethers such as benzoin methyl ether or benzoin isopropyl ether, substituted benzoin ethers such as 2-methyl-2-hydroxylpropiophenone, aromatic sulfonyl chlorides such as 2-naphthalenesulfonyl chloride, and photoactive oxides such as 1-phenyl-1,2-propanedione-2-(o-ethoxycarbonyl)oxime. An example of a commercially available photoinitiator is Irgacure™ 651 available from Ciba-Geigy Corporation, having the formula 2,2-dimethoxy-1,2-diphenylethane-1-one). Generally, the photoinitiator is present in an amount of about 0.005 to 1 weight percent based on the weight of the monomers. Examples of suitable thermal initiators include AIBN and peroxides.

The mixture of the polymerizable monomers may also contain a crosslinking agent, or a combination of crosslinking agents, to increase the shear strength ofthe adhesive. Useful crosslinking agents include substituted triazines such as 2,4,-bis(trichloromethyl)-6-(4-methoxy phenyl)-s-triazine, 2,4-bis(trichloromethyl)-6-(3,4-dimethoxyphenyl)-s-triazine, and the chromophore-substituted halo-s-triazines disclosed in U.S. Patent Nos 4,329,384 and 4,330,590 (Vesley). Other useful crosslinking agents include multifunctional alkyl acrylate monomers such as trimetholpropane triacrylate, pentaerythritol tetra-acrylate, 1,2 ethylene glycol diacrylate, 1,4 butanediol diacrylate, 1,6 hexanediol diacrylate, and 1,12 dodecanol diacrylate. Various other crosslinking agents with different molecular weights between (meth)acrylate functionality would also be useful. Generally, the crosslinker is present in an amount of about 0.005 to 1 weight percent based on the combined weight of the monomers.

Other materials which can be blended with the polymerizable monomers prior to coating include plasticizers, coloring agents, reinforcing agents, fire retardants, foaming agents, thermally conductive agents, electrically conductive agents, post-curing agents, and post-curing agent curatives and their accelerators.

Where multi-layer tape constructions are desirable, one method of construction is multi-layer coating using conventional techniques. For example, the coatings may be applied concurrently (e.g., through a die coater), after which the entire multi-layer structure is cured all at once. The coatings may also be applied sequentially whereby each individual layer is partially or completely cured prior to application of the next layer.

The compositions are useful for damping vibrations when in contact with vibratory parts, especially when the vibratory parts are made of oily metals or polymeric materials.

The vibration damping composites of the invention are particularly useful in automobile construction in which the composites can be applied directly to an automobile panel, such as a door panel, during the stamping stage without requiring cleaning and removal of the mill oils on the panel. During the stamping stage, the metal, usually cold rolled steel or aluminum, is still coated with mill oils used to prevent rust or oxidation.

The sheet materials are also useful as vibration dampers, either as a constrained layer damper or as a free layer damper, for oily engine covers to damp vibrations and reduce the noise from the engine. Sheet materials of the invention are especially advantageous in that they can be applied to the cover without requiring tedious cleaning with solvents and/or detergents to remove the oil. In this application, the sheet materials do not need to be pressure-sensitive and can be applied by heating the engine cover above the T_{g} of the damper.

The vibration damping materials ofthe invention are also of use in damping applications where outgassing is of concern. Such applications include computer components such as in suspension dampers for the read/write head, free layer or constrained layer dampers for disk drive covers, or for sealing together the disk drive covers. The vibration dampers of the invention can be made without acid; they may be used advantageously where corrosion is a potential problem, such as on bare copper surfaces.

Other useful applications of the invention include vibration damping for shock absorbers and seismic dampers for buildings. The sheet materials can be die cut to a desired shape, for example a donut shape or a circular disk, or they can be formed in a mold in the desired configuration, such as a molded slab.

The invention will now be further described by way of the following examples.

### Vibration Damping Constructions

### Example 1

A composition was prepared by mixing 67 parts isooctyl acrylate, 32 parts isobornyl acrylate, 1 part acrylic acid, and 0.04 part benzyl dimethyl ketal photoinitiator (KB-1 from Sartomer). The mixture was partially polymerized in a nitrogen rich atmosphere using fluorescent black lights to a syrup having a viscosity of about 3.Pa.s (3000 centipoise). An additional 0.16 part KB-1 photoinitiator and 0.15 part hexane dioldiacrylate were added to the syrup, which was then mixed and knife coated to a thickness of about 50 microns onto a silicone-treated, polyethylene coated paper release liner. The coated mixture was exposed to ultraviolet radiation having a major portion of the spectral output between 300 and 400 nanometers, with a maximum at 351 nanometers, and at an intensity of about 2 milliWatts/cm². The total energy was about 650 milliJoules/cm². The resulting sheet material was then laminated to a 0.165 mm thick panel of cold rolled steel to form a constrained layer damper.

The constrained layer damper was cut to a dimension of 20.3 centimeters by 20.3 centimeters and laminated to an automotive door panel. The door panel with the damper was suspended with Tygon tubing, and an accelerometer (Model 22 from Endevco Co., San Juan Capistrano, CA) was attached to the door panel and wired to a Fast Fourier Transform (FFT) analyzer (Model 2630 Analyzer from Tektronix). The analyzer was also attached to an impact hammer (obtained from PCB, DePew, NY). In testing, the impact hammer was used to strike the panel, which caused various modes of excitation or vibration to occur within the panel. The acceleration was then measured as a function of time, and the FFT analyzer was used to convert the results to acceleration as a function of frequency. The frequencies (FREQ) of the first eight modes were determined using STAR Modal software from Structural Measurement Systems, Milipitas, CA. The average loss factors (AVG) for all eight modes were also calculated.

In comparison, the test was also conducted on the same door panel without a damper, and also with a commercially accepted damper (measuring 20.3 cm by 20.3 cm) having 1.78 millimeters of a black mastic material on a 0.10 mm thick aluminum constraining layer. All of the test results are shown in Table IV-1.

**TABLE IV-1**

| Mode | Example 1 | | No Damper | | Commercial Damper | |
|---|---|---|---|---|---|---|
| | FREQ-HZ | LOSS | FREQ-HZ | LOSS | FREQ-HZ | LOSS |
| 1 | 61.8 | 0.01036 | 61.5 | 0.00326 | 60.4 | .00222 |
| 2 | 76.0 | 0.00800 | 75.9 | 0.00718 | 76.1 | 0.00768 |
| 3 | 99.1 1 | 0.00750 | 99.5 | 0.00538 | 98.4 | 0.00544 |
| 4 | 117.0 | 0.00630 | 116.9 | 0.0037 | 119.4 | 0.00212 |
| 5 | 135.1 1 | 0.01512 | 130.9 | 0.00674 | 130.7 | 0.00942 |
| 6 | 140.0 | 0.02182 | 136.0 | 0.00502 | 136.3 | 0.01988 |
| 7 | 146.4 | 0.00608 | 142.5 | 0.00350 | 143.5 | 0.00212 |
| 8 | 151.0 | 0.01614 | 148.6 | 0.00696 | 147.9 | 0.01386 |
| AVG | --- | 0.01142 | --- | 0.00522 | --- | 0.00790 |

The data in Table 1 show that vibration damping composites, i.e., constrained layer dampers, of the invention provide superior damping as compared to commercial products as shown by the greater loss factor.

Other embodiments are within the following claims.

## Claims

1. A damping construction comprising at least one layer of a viscoelastic material applied to a vibratory solid article, said viscoelastic material comprising the reaction product of starting materials consisting of:
(a) 3-97 parts by weight of an acrylic acid ester of a monohydric alcohol whose homopolymer has a Tg less than 0°C;
(b) 3-97 parts by weight of a non-polar ethylenically unsaturated monomer whose homopolymer has a solubility parameter as measured by the Fedors method as described in Fedors, Polym. Eng. ans Sci., 14 : 147 (1974) of no greater than 10.50 and a Tg greater than 15°C; and
(c) 0-5 parts by weight of a polar ethylenically unsaturated monomer whose homopolymer has a solubility parameter as measured by the Fedors method as described in Fedors, Polym. Eng. and Sci., 14:147 (1974) of greater than 10.50 and a Tg greater than 15°C,
the sum of the parts by weight of said acrylic acid ester, said non-polar ethylenically unsaturated monomer, and said polar ethylenically unsaturated monomer being equal to 100 parts,
and substantially no epoxy component,
said viscoelastic material being substantially non-tacky at room temperature.

2. The damping construction of claim 1, wherein the amount of said acrylic acid ester is between 40 and 85 parts by weight.

3. The damping construction of claim 1, wherein the amount of said non-polar ethylenically unsaturated monomer is between 15 and 60 parts by weight.

4. The damping construction of claim 1, wherein said non-polar ethylenically unsaturated monomer is a monomer other than a methacrylate monomer.

5. The damping construction of claim 1, wherein said non-polar ethylenically unsaturated monomer is selected from the group consisting of 3,3,5-trimethylcyclohexyl acrylate, cyclohexyl acrylate, isobornyl acrylate, N-octyl acrylamide, t-butyl acrylate, and combinations thereof.

6. The damping construction of claim 1, wherein said non-polar ethylenically unsaturated monomer is isobornyl acrylate.

7. The damping construction of claim 1, wherein said starting materials consist of isooctyl acrylate and isobornyl acrylate.

8. A method for damping vibrations comprising applying at least one layer of a viscoelastic material to a vibratory solid article,
said viscoelastic material comprising the reaction product of starting materials consisting of:
(a) 3-97 parts by weight of an acrylic acid ester of a monohydric alcohol having 4-18 carbon atoms whose homopolymer has a Tg less than 0°C;
(b) 3-97 parts by weight of a non-polar ethylenically unsaturated monomer whose homopolymer has a solubility parameter as measured by the Fedors method as described in Fedors, Polym. Eng. and Sci., 14 : 147 (1974) of no greater than 10.50 and a Tg greater than 15°C; and
(c) 0-5 parts by weight of a polar ethylenically unsaturated monomer whose homopolymer has a solubility parameter as measured by the Fedors method as described in Fedors, Polym. Eng. and Sci., 14:147 (1974) of greater than 10.50 and a Tg greater than 15°C,
the sum of the parts by weight of said acrylic acid ester, said non-polar ethylenically unsaturated monomer, and said polar ethylenically unsaturated monomer being equal to 100 parts,
substantially no epoxy component,
said viscoelastic material being substantially non-tacky at room temperature.

## Patentansprüche

1. Dämpfende Konstruktion, umfassend mindestens eine Schicht eines viskoelastischen Materials auf einem vibrierenden Festkörper, wobei das viskoelastische Material das Reaktionsprodukt von Ausgangsmaterialien umfaßt, bestehend aus:
(a) 3-97 Gewichtsteilen eines Acrylsäureesters eines einwertigen Alkohols, dessen Homopolymer eine T_{g} von weniger als 0°C hat;
(b) 3-97 Gewichtsteilen eines unpolaren, ethylenisch ungesättigten Monomers, dessen Homopolymer einen Löslichkeitsparameter von nicht größer als 10,50, gemessen nach dem Fedors-Verfahren, wie in Fedors, Polym. Eng. Sci., 14:147 (1974) beschrieben, und eine T_{g} von mehr als 15°C hat; und
(c) 0-5 Gewichtsteilen eines polaren, ethylenisch ungesättigten Monomers, dessen Homopolymer einen Löslichkeitsparameter von größer als 10,50, gemessen nach dem Fedors-Verfahren, wie in Fedors, Polym. Eng. Sci., 14:147 (1974) beschrieben, und eine T_{g} von mehr als 15°C hat,
wobei die Summe der Gewichtsteile des Acrylsäureesters, des unpolaren, ethylenisch ungesättigten Monomers und des polaren, ethylenisch ungesättigten Monomers gleich 100 Gewichtsteile ist,
und im wesentlichen keiner Epoxidkomponente,
wobei das viskoelastische Material bei Raumtemperatur im wesentlichen nichtklebrig ist.

2. Dämpfende Konstruktion nach Anspruch 1, wobei die Menge des Acrylsäureesters zwischen 40 und 85 Gewichtsteilen liegt.

3. Dämpfende Konstruktion nach Anspruch 1, wobei die Menge des unpolaren, ethylenisch ungesättigten Monomers zwischen 15 und 60 Gewichtsteilen liegt.

4. Dämpfende Konstruktion nach Anspruch 1, wobei das unpolare, ethylenisch ungesättigte Monomer kein Methacrylatmonomer ist.

5. Dämpfende Konstruktion nach Anspruch 1, wobei das unpolare, ethylenisch ungesättigte Monomer aus 3,3,5-Trimethylcyclohexylacrylat, Cyclohexylacrylat, Isobornylacrylat, N-Octylacrylamid, t-Butylacrylat und Kombinationen davon ausgewählt ist.

6. Dämpfende Konstruktion nach Anspruch 1, wobei das unpolare, ethylenisch ungesättigte Monomer Isobornylacrylat ist.

7. Dämpfende Konstruktion nach Anspruch 1, wobei die Ausgangsmaterialien aus Isooctylacrylat und Isobornylacrylat bestehen.

8. Verfahren zur Dämpfung von Vibrationen, umfassend das Auftragen mindestens einer Schicht aus einem viskoelastischen Material auf einen vibrierenden Festkörper, wobei das viskoelastische Material das Reaktionsprodukt von Ausgangsmaterialien umfaßt, bestehend aus:
(a) 3-97 Gewichtsteilen eines Acrylsäureesters eines einwertigen Alkohols mit 4-18 Kohlenstoffatomen, dessen Homopolymer eine T_{g} von weniger als 0°C hat;
(b) 3-97 Gewichtsteilen eines unpolaren, ethylenisch ungesättigten Monomers, dessen Homopolymer einen Löslichkeitsparameter von nicht größer als 10,50, gemessen nach dem Fedors-Verfahren, wie in Fedors, Polym. Eng. Sci., 14:147 (1974) beschrieben, und eine T_{g} von mehr als 15°C hat; und
(c) 0-5 Gewichtsteilen eines polaren, ethylenisch ungesättigten Monomers, dessen Homopolymer einen Löslichkeitsparameter von größer als 10,50, gemessen nach dem Fedors-Verfahren, wie in Fedors, Polym. Eng. Sci., 14:147 (1974) beschrieben, und eine Tg von mehr als 15°C hat,
wobei die Summe der Gewichtsteile des Acrylsäureesters, des unpolaren, ethylenisch ungesättigten Monomers und des polaren, ethylenisch ungesättigten Monomers gleich 100 Gewichtsteile ist,
und im wesentlichen keiner Epoxidkomponente,
wobei das viskoelastische Material bei Raumtemperatur im wesentlichen nichtklebrig ist.

## Revendications

1. Elément amortissant comprenant au moins une couche d'un matériau viscoélastique appliqué sur un article vibratoire, ledit matériau viscoélastique comprenant le produit de réaction des matériaux de départ constitués de :
(a) 3 à 97 parties en poids d'un ester d'acide acrylique d'un alcool monohydroxylé dont l'homopolymère a une Tᵥ inférieure à 0°C;
(b) 3 à 97 parties en poids d'un monomère non polaire éthyléniquement insaturé dont l'homopolymère a un paramètre de solubilité mesuré par la méthode de Fedors telle que décrite dans Fedors, Polym. Eng. and Sci., 14 : 147 (1974) non supérieur à 10,50 et une Tᵥ supérieure à 15°C; et
(c) 0 à 5 parties en poids d'un monomère polaire éthyléniquement insaturé dont l'homopolymère a un paramètre de solubilité mesuré par la méthode de Fedors telle que décrite dans Fedors, Polym. Eng. and Sci., 14 : 147 (1974) supérieur à 10,50 et une Tᵥ supérieure à 15°C,
la somme des parties en poids dudit ester d'acide acrylique, dudit monomère non polaire éthyléniquement insaturé, et dudit monomère polaire éthyléniquement insaturé étant égale à 100 parties,
et ne contenant essentiellement pas de composant époxy, ledit matériau viscoélastique étant essentiellement non collant à température ambiante.

2. Elément amortissant selon la revendication 1, dans lequel la quantité dudit ester d'acide acrylique est entre 40 et 85 parties en poids.

3. Elément amortissant selon la revendication 1, dans lequel la quantité dudit monomère non polaire éthyléniquement insaturé est entre 15 et 60 parties en poids.

4. Elément amortissant selon la revendication 1, dans lequel ledit monomère non polaire éthyléniquement insaturé est un monomère différent d'un monomère de type méthacrylate.

5. Elément amortissant selon la revendication 1, dans lequel ledit monomère non polaire éthyléniquement insaturé est choisi parmi l'acrylate de 3,3,5-triméthylcyclohexyle, l'acrylate de cyclohexyle, l'acrylate d'isobornyle, le N-octylacrylamide, l'acrylate de tert.-butyle et des combinaisons de ceux-ci.

6. Elément amortissant selon la revendication 1, dans lequel ledit monomère non polaire éthyléniquement insaturé est l'acrylate d'isobornyle.

7. Elément amortissant selon la revendication 1, dans lequel lesdits matériaux de départ sont constitués de l'acrylate d'isooctyle et l'acrylate d'isobornyle.

8. Procédé d'amortissement des vibrations comprenant l'application d'au moins une couche d'un matériau viscoélastique sur un article solide vibratoire,
ledit matériau viscoélastique comprenant le produit de réaction des matériaux de départ constitués de :
(a) 3 à 97 parties en poids d'un ester d'acide acrylique d'un alcool monohydroxylé ayant 4 à 18 atomes de carbone dont l'homopolymère a une Tᵥ inférieure à 0°C;
(b) 3 à 97 parties en poids d'un monomère non polaire éthyléniquement insaturé dont l'homopolymère a un paramètre de solubilité mesuré par la méthode de Fedors telle que décrite dans Fedors, Polym. Eng. and Sci., 14 : 147 (1974) non supérieur à 10,50 et une Tᵥ supérieure à 15°C; et
(c) 0 à 5 parties en poids d'un monomère polaire éthyléniquement insaturé dont l'homopolymère a un paramètre de solubilité mesuré par la méthode de Fedors telle que décrite dans Fedors, Polym. Eng. and Sci., 14 : 147 (1974) supérieur à 10,50 et une Tᵥ supérieure à 15°C,
la somme des parties en poids dudit ester d'acide acrylique, dudit monomère non polaire éthyléniquement insaturé, et dudit monomère polaire éthyléniquement insaturé étant égale à 100 parties,
et ne contenant essentiellement pas de composant époxy, ledit matériau viscoélastique étant essentiellement non collant à température ambiante.
